# EUROPEAN PATENT SPECIFICATION

(11) **EP 2 048 267 B1**
(45) Date of publication and mention of the grant of the patent: **20.11.2013**
(21) Application number: 07791065.1
(22) Date of filing: 20.07.2007
(51) Int. Cl.: C30B 25/00, C30B 25/02, C30B 29/04, C30B 33/00, C30B 31/22, H01L 21/02

(54) **PROCESS FOR PRODUCING SINGLE-CRYSTAL SUBSTRATE WITH OFF ANGLE**
VERFAHREN ZUR HERSTELLUNG VON EINKRISTALLSUBSTRAT MIT OFF-WINKEL
PROCESSUS DE FABRICATION DE SUBSTRAT MONOCRISTALLIN AVEC ANGLE DE DÉPORT

(30) Priority: 27.07.2006 JP 2006204248
(43) Date of publication of application: 15.04.2009
(73) Proprietor: National Institute of Advanced Industrial Science and Technology, Tokyo 100-8921 (JP)
(72) Inventor: MOKUNO, Yoshiaki, Ikeda-shi Osaka 5638577 (JP); CHAYAHARA, Akiyoshi, Ikeda-shi Osaka 5638577 (JP); YAMADA, Hideaki, Ikeda-shi Osaka 5638577 (JP); SHIKATA, Shinichi, Tsukuba-shi Ibaraki 3058561 (JP)
(74) Representative: Müller-Boré & Partner Patentanwälte
(86) International application number: PCT/JP2007/064327
(87) International publication number: WO 2008/013108

(56) References cited:
- EP-A1- 1 667 223
- JP-A- 2005 298 319
- US-A- 5 891 575
- PEHRSSON P E ET AL: "HOMOEPITAXIAL MOSAIC GROWTH AND LIFTOFF OF DIAMOND FILMS", MATERIALS RESEARCH SOCIETY SYMPOSIUM PROCEEDINGS; [MATERIALS RESEARCH SOCIETY SYMPOSIUM PROCEEDINGS], MATERIALS RESEARCH SOCIETY, USA, vol. 416, 1 January 1996 (1996-01-01), pages 51-56, XP008063923, ISBN: 978-1-55899-828-5
- OKUSHI H ET AL: "Device-grade homoepitaxial diamond film growth", JOURNAL OF CRYSTAL GROWTH, ELSEVIER, AMSTERDAM, NL, vol. 237-239, 1 April 2002 (2002-04-01), pages 1269-1276, XP004355980, ISSN: 0022-0248, DOI: DOI:10.1016/S0022-0248(01)02144-3
- POSTHILL J.B. ET AL.: 'Method of fabricating a free-standing diamond single crystal using growth from the vapor phase' JOURNAL OF APPLIED PHYSICS vol. 79, 1996, pages 2722 - 2727, XP000593851
- TSUNO T. ET AL.: 'Growth rate and surface morphology of diamond homoepitaxial films on misoriented (001) substrates' JAPANESE JOURNAL OF APPLIED PHYSICS vol. 35, 1996, pages 4724 - 4727, XP000735392
- OKUSHI H. ET AL.: 'Device-grade homoepitaxial diamond film growth' JOURNAL OF CRYSTAL GROWTH vol. 237-239, 2002, pages 1269 - 1276, XP004355980
- TZENG Y. ET AL.: 'Free-standing single-crystalline chemically vapor deposited diamond films' APPLIED PHYSICS LETTERS vol. 63, 1993, pages 2216 - 2218, XP000404426
- SAMLENSKI R. ET AL.: 'Liftoff-technique of single-crystal diamond plates: study of the lattice damage of the implanted substrates and the crystalline quality of the homoepitaxial films by ion channeling' DIAMOND AND RELATED MATERIALS vol. 6, 1997, pages 149 - 152, XP004061156

## Description

### TECHNICAL FIELD

The present invention relates to a process for producing a single-crystal substrate with an off-angle that is suitable as a substrate for growing a semiconductor diamond by a vapor-phase synthesis method, or the like.

### BACKGROUND ART

Diamond, which exhibits outstanding properties as a semiconductor, is expected to be a material for use in semiconductor devices, such as high-frequency and high-output devices, ultraviolet emitting devices, and the like. A single-crystal diamond is grown mainly by methods such as a high-pressure synthesis method, a vapor-phase synthesis method, and the like; a semiconductor-grade, high-quality diamond, in particular, is synthesized by homoepitaxial growth on a diamond substrate using a vapor-phase synthesis method.

However, during the epitaxial growth of a diamond using a vapor-phase synthesis method, many defects such as non-epitaxial crystallites and hillocks tend to occur, and these defects cause electrical properties to deteriorate when the diamond is used for device preparation.

Examples of methods for reducing the occurrence of defects in the vapor-phase synthesis method for diamonds include:
(1) a method wherein a small amount of an impurity component is added to a source gas to allow preferential growth of a specific crystal plane;
(2) a method wherein conditions under which a specific crystal plane can be preferentially oriented are selected; and
(3) a method wherein a substrate whose surface has a small inclination (an off-angle) with respect to a crystal plane capable of epitaxial growth is used, and a diamond is grown on this substrate by step-flow growth.

It has been reported that, according to Method (1) above, in the case of diamond growth on the most commonly used (100) face, the addition of a small amount of nitrogen as an impurity allows preferential growth of the (100) face, thereby producing a macroscopically flat surface that is free of non-epitaxial crystallites and hillocks (see, for example, Non-Patent Document 1). With this method, however, the electrical properties may be deteriorated by defects associated with nitrogen incorporated into the crystal during growth; thus, the excellent electrical properties possessed by diamond cannot be fully exhibited.

According to Method (2), even if the growth conditions under which a specific crystal plane can be preferentially oriented are obtained, a high-temperature high-pressure synthetic diamond substrate, which is typically used as a substrate, has poor uniformity, and it is difficult to fully get rid of damage caused by polishing. Thus, when a diamond is grown on this diamond substrate by a vapor-phase synthesis method, non-epitaxial crystallites and hillocks tend to occur regionally, making it difficult to produce a macroscopically flat growth surface.

On the other hand, according to Method (3), the use of a substrate with an off-angle with respect to a crystal plane capable of epitaxial growth increases the density of the steps that serve as a starting point of crystal growth in a vapor-phase synthesis method, thereby promoting growth in the step-flow mode. Consequently, crystals grow in the form of lateral growth, which significantly reduces the occurrence of non-epitaxial crystallites and hillocks, thereby producing a macroscopically flat growth surface with high reproducibility (see, for example, Non-Patent Document 2).

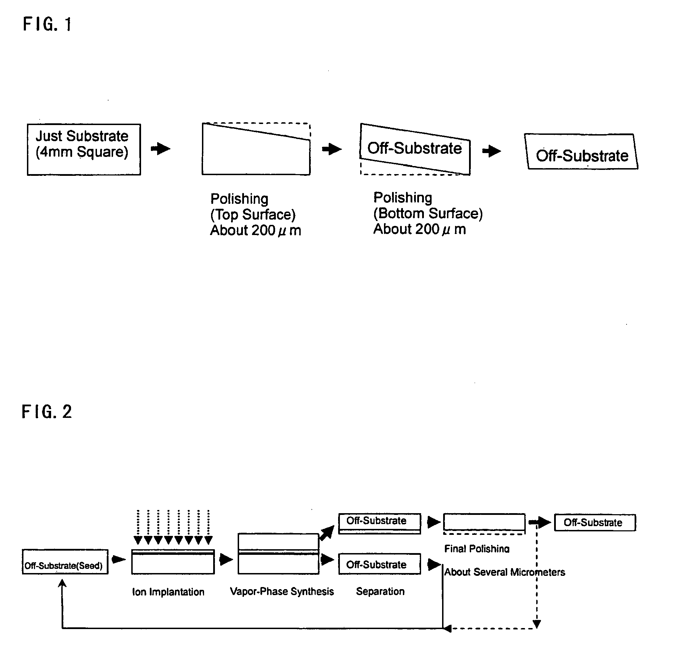

With Method (3), however, in order to reproducibly obtain a vapor-phase synthetic diamond film with fewer surface defects, it is necessary to use a substrate whose surface has been processed to have an off-angle with respect to a specific crystal plane (hereinafter the substrate is sometimes referred to as an "off-substrate"). Off-substrates have been conventionally produced by polishing a single-crystal diamond to form a predetermined off-angle. Representative examples of polishing methods employed are mechanical polishing methods, such as scaife polishing, wherein polishing is performed by pressing the diamond against a rapidly rotating cast-iron plate. However, to produce an off-substrate from a substrate without an off-angle (a "just substrate"), it is necessary to cut off the diamond by polishing, as shown in FIG. 1. For example, when an off-substrate with an off-angle of 3° is produced from a 4-mm-square single-crystal diamond plate, the amount of polishing is about 200 µm per surface; when both surfaces are polished in parallel with each other, an amount of about 400 µm is lost. This corresponds to a thickness comparable to that of about one usual semiconductor wafer. In the case of a 10-mm-square single-crystal diamond plate, which is currently the maximum available size, the amount of polishing reaches about 1 mm. Moreover, since diamond is the hardest material, it is difficult to polish; thus, a considerable amount of time is required to cut off such large amounts of diamond by scaife polishing, and obtain a polished surface with a low surface roughness that suits the vapor-phase growth of a semiconductor-grade diamond. Further, because of large processing errors due to mechanical polishing, it has been extremely difficult to control the off-angle and mass-produce substrates with an identical off-angle.

As described above, when off-substrates are produced only by polishing, great losses of diamond are produced, leading to a great increase in manufacturing costs; in addition, it is difficult to mass-produce substrates with a precisely controlled, identical off-angle.

By the way, because generally used high-temperature high-pressure synthetic diamond substrates are expensive, several methods have been proposed for repeated use of these substrates.

Parikh et al. have shown that, when oxygen ions accelerated to a high energy of several mega-electron volts are implanted into a diamond to form a non-diamond layer, and then the layer is annealed in an oxygen atmosphere, a single-crystal film with a thickness of the order of micrometers can be separated from the substrate (see, for example, Non-Patent Document 3). According to this method, even though a small amount of the substrate is lost, an epitaxially grown film separated from the substrate can be obtained by growing an epitaxial film after the ion implantation prior to separation, or by epitaxially growing a diamond on the separated film.

Marchywka et al. have proposed a method wherein a non-diamond layer formed as above is removed by electrochemical etching, thereby separating a diamond film epitaxially grown on an ion-implanted substrate from the substrate (see, for example, Patent Document 1).

Yamamoto et al. have proposed a method wherein a stacked film of a semiconductor diamond layer and an insulating diamond layer is epitaxially grown, or an insulating diamond layer is made conductive by ion implantation, and subsequently, the semiconductor diamond layer is subjected to electrochemical etching, or the ion-implanted layer is subjected to electrochemical etching or electric discharge machining, thereby separating the insulating diamond film (see, for example, Patent Document 2).

According to these methods, diamond substrates can be produced at low cost, without great losses of expensive substrates due to polishing and the like; however, all of these methods are only intended for just substrates.
Furthermore, P. Pehrsson et al., in "homoepitaxial mosaic growth and lift-off of diamond films", Mat. Res. Soc. Symp. Proc., vol. 416 (1996) 51-56 shows the lift-off after implantation of diamond films having an off-angle.
EP 1 667 223 A show a method of implantation, bonding and detaching films in a repeated process.
Patent Document 1: U.S. Pat. No. 5,587,210
Patent Document 2: Japanese Unexamined Patent Publication No. 2005-272197
Non-Patent Document 1: "The effect of nitrogen addition during high-rate homoepitaxial growth of diamond by microwave plasma CVD", A. Chayahara, Y. Mokuno, Y. Horino, Y. Takasu, H. Kato, H. Yoshikawa, and N. Fujimori; Diamond and Related Materials 13 (2004) 1954-1958
Non-Patent Document 2: "Device-grade homoepitaxial diamond film growth", H. Okushi, H. Watanabe, S. Ri, S. Yamanaka, and D. Takeuchi; Journal of Crystal Growth 237-239 (2002) 1269-1276 Non-Patent Document 3: "Single-crystal diamond plate liftoff achieved by ion implantation and subsequent annealing", N. R. Parikh, J. D. Hunn, E. McGucken, M. L. Swanson, C. W. White, R. A. Rudder, D. 6. Malta, J. B. Posthill, and R. J. Markunas; Appl. Phys. Lett. 61 (1992) 3124-3126

### DISCLOSURE OF THE INVENTION

### PROBLEMS TO BE SOLVED BY THE INVENTION

The invention was made in view of the above-described state of the prior art. A principal object of the invention is to provide a novel process for producing an off-substrate that is usable in vapor-phase synthesis of a single crystal, the process being capable of reducing the manufacturing costs, and producing off-substrates with an identical off-angle easily and in large quantities.

### MEANS FOR SOLVING THE PROBLEMS

The inventors conducted extensive research to achieve the above-mentioned object, and consequently arrived at the following novel finding.

According to a process wherein a diamond substrate (an off-substrate), whose surface has been precisely polished to have a predetermined off-angle with respect to a specific crystal plane, is used as a seed crystal, and a non-diamond layer is formed by ion implantation near the surface of the seed crystal, after which a diamond is grown by a vapor-phase synthesis method; a satisfactory diamond layer with substantially less non-epitaxial crystallites and hillocks can be formed by step-flow growth, and the grown diamond layer can be easily separated from the off-substrate along the non-diamond layer. This allows diamond substrates with an identical off-angle to the seed crystal to be produced easily and in a short period of time. By repeating this process, diamond substrates with an identical off-angle can be produced easily and in large quantities. Moreover, this process is not limited to diamonds, and is similarly applicable to any of various materials capable of epitaxial growth by a vapor-phase synthesis method.

The invention was accomplished as a result of further extensive research based on the above-mentioned novel finding, and provides a process as set forth in claim 1.
The process further having a step, wherein a method for separating the grown diamond layer from the substrate is an electrochemical etching method, an electric discharge machining method, or a thermal oxidation method or
wherein a graphitized non-diamond layer is formed near the surface of the substrate by ion implantation and, or
wherein the vapor-phase synthesis method is a plasma CVD method, and the method for separating the grown diamond layer from the substrate is an electrochemical etching method.

### EFFECTS OF THE INVENTION

In accordance with the process of the invention, off-substrates, which have been conventionally produced by polishing, can be produced simply and in a short period of time, with extremely high controllability. Moreover, the seed crystal used in the production of an off-substrate or the resulting off-substrate can be used again as a seed crystal, thus dramatically increasing the number of off-substrates to be produced, leading to the production of off-substrates at low cost and in large quantities.

Thus, by growing a diamond according to a vapor-phase synthesis method on the off-substrate of the single-crystal diamond obtained by the process of the invention, a semiconductor-grade, high-quality diamond can be provided in large quantities at low cost.

### BRIEF DESCRIPTION OF THE DRAWINGS

FIG. 1 is a schematic diagram showing the steps of producing an off-substrate using a conventional method; and
FIG. 2 is a schematic diagram showing the steps of producing a single-crystal substrate with an off-angle according to the invention.

### BEST MODE FOR CARRYING OUT THE INVENTION

FIG. 2 is a schematic diagram showing the steps of producing a single-crystal substrate with an off-angle according to the invention. Referring to FIG. 2, the invention is described below in greater detail.

### Off-Substrate

In the process of the invention, as a seed crystal (a substrate) for crystal growth by a vapor-phase synthesis method, a material capable of epitaxial growth by a vapor-phase synthesis method, whose surface has an off-angle, i.e., an angle of inclination with respect to a crystal plane capable of epitaxial growth, is used (hereinafter the crystal plane is sometimes referred to as a "reference crystal plane" and the substrate is referred to as an off-substrate).

The reference crystal plane may be suitably selected from crystal planes capable of epitaxial growth, according to the type of the seed crystal. For example, for growing a semiconductor-grade diamond, the (100) plane, (111) plane, or the like of the diamond crystal can typically be used as a reference crystal plane.

The degree of the off-angle is not limited, and may be an angle of inclination such that crystal growth is enabled by step-flow growth, while maintaining the off-angle. For example, when the (100) plane, (111) plane, or the like of the diamond is used as a reference crystal plane, the off-angle is preferably from, for example, about 0.05 to about 10°, and more preferably from about 0.05 to about 5°.

The method of forming an off-angle is not limited; a predetermined off-angle may be formed according to a conventional method such as mechanical polishing, etc. For example, when a diamond is used as a seed crystal, methods such as scaife polishing, wherein polishing is performed by pressing the diamond against a rapidly rotating cast-iron plate (a scaife), can be employed.

### Ion Implantation

Next, ions are implanted into the off-substrate from one surface thereof to form an ion-implanted layer having a deteriorated crystal structure near the surface of the off-substrate. The ion implantation method is a method of irradiating a sample with swift ions. In general, ion implantation is performed as follows: a desired element is ionized, and the resulting ions are accelerated by applying a high voltage thereto, after which the ions are mass-separated, and ions with a desired level of energy are directed to the sample. Alternatively, it may be performed as follows: the sample is immersed in plasma, and negative high-voltage pulses are applied to the sample to attract positive ions in the plasma to the sample. Examples of implanted ions include carbon, oxygen, argon, helium, protons, and the like.

The ion implantation energy may be in the range of about 10 keV to about 10 MeV, which is typically used in ion implantation. Implanted ions are distributed mainly in an average depth (projectile range), with a certain width of depth; the average depth is determined according to the type and energy of the ions, as well as the type of the sample. Damage to the sample is the maximum in the vicinity of the projectile range where ions stop, but the surface side of the off-substrate above the vicinity of the projectile range also experiences a certain degree of damage caused by the passage of ions. The projectile range and the degree of damage can be calculated and predicted using a Monte Carlo simulation code, such as the SRIM code.

By implanting ions into the off-substrate, when the dose exceeds a certain level, the surface side of the off-substrate above the vicinity of the projectile range undergoes a chemical or physical change to deteriorate the crystal structure, thereby facilitating the separation of the surface portion above the deteriorated portion. When, for example, a diamond is used as a seed crystal, the diamond structure is destroyed at the surface side above the vicinity of the projectile range, causing graphitization to proceed.

The depth and thickness of the resulting deteriorated portion vary depending on the type of the ion used, the ion implantation energy, the dose, and the like. Therefore, these conditions are determined so that a deteriorated layer that can be separated is formed near the projectile range, and the surface of the off-substrate can maintain a degree of crystallinity such that epitaxial growth is enabled by a vapor-phase synthesis method. More specifically, in the case of, for example, a diamond, the maximum atomic density of implanted ions must be 1 × 10²⁰ atoms/cm³ or more; in order to ensure the formation of a non-diamond layer, the maximum atomic density is preferably 1 × 10²¹ atoms/cm³ or more. The degree of damage to a surface capable of epitaxial growth must be such that the number of vacancies produced near the surface of the diamond is 1 × 10²³ (vacancies)/cm³ or less, and preferably 4 × 10²² (vacancies)/cm³ or less.

For example, when a diamond is used as a seed crystal, and carbon ions are implanted at an implantation energy of 3 MeV, the ion dose may be from about 1 × 10¹⁶ to about 1 × 10¹⁷ ions/cm². In this case, if the ion dose is too high, the crystallinity of the surface deteriorates, making epitaxial growth difficult; whereas if the dose is too low, a non-diamond layer is not sufficiently formed, making it difficult to separate the grown diamond layer.

### Crystal Growth by a Vapor-Phase Synthesis Method

Next, a single crystal is grown on the ion-implanted off-substrate by a vapor-phase synthesis method. The vapor-phase synthesis method is not limited; a known method is applicable, such as, for example, a microwave plasma CVD method, a hot filament method, a DC discharge method, etc.

For example, when a diamond off-substrate is used as a seed crystal, a single-crystal diamond film with high purity can be grown by using, in particular, a microwave plasma CVD method. Specific production conditions are not limited; a single-crystal diamond can be grown according to known conditions. For example, a gas mixture of methane and hydrogen can be used as a source gas, and the addition of nitrogen gas thereto further improves the growth rate. Specific conditions for growing a diamond are now described by way of example. In the gas mixture of hydrogen, methane, and nitrogen used as a reaction gas, methane is preferably supplied in a proportion of from about 0.01 to about 0.33 mol per mol of hydrogen supplied, and nitrogen is preferably supplied in a proportion of from about 0.0005 to about 0.1 mol per mol of methane supplied. The pressure inside the plasma CVD apparatus can be typically from about 13.3 to about 40 kPa. Microwaves typically used are those having a frequency of 2.45 GHz, 915 MHz, or like frequencies which are industrially or scientifically sanctioned. The microwave power is not limited, and is typically from about 0.5 to about 5 kW. Within these ranges, the conditions may be adjusted so that the temperature of the substrate (a single-crystal diamond seed crystal) is increased to a temperature ranging from about 900 to about 1,300°C. Maintaining the substrate at such temperatures promotes the graphitization of the non-diamond layer formed by ion implantation.

In the invention, when a single-crystal diamond is grown on an off-substrate, using a microwave plasma CVD method according to the above-described method, step-flow growth is promoted, and the occurrence of non-epitaxial crystallites and hillocks is completely eliminated. Moreover, the addition of nitrogen, in particular, dramatically increases the growth rate, and enables the growth of a single-crystal diamond having a thickness necessary for a substrate (about 300 µm) with a high yield in a short period of time.

### Step of Separating the Crystal Layer

Subsequent to the crystal growth using the vapor-phase synthesis method according to the above-described method, the resulting crystal layer is separated from the off-substrate. At this time, the crystal layer is easily separated from the portion of the above-described ion-implanted layer formed near the surface of the off-substrate by ion implantation. For example, when a diamond is used as a seed crystal, the grown diamond layer is easily separated from the portion of the graphitized non-diamond layer formed in the substrate.

The method of separating the grown crystal layer is not limited; for example, the above-mentioned methods, such as a thermal oxidation method, an electrochemical etching method, an electric discharge machining method, etc., can be applied.

When the off-substrate is made of a diamond, graphitization proceeds in the non-diamond layer formed by ion implantation to increase the conductivity; therefore, the non-diamond layer can be etched away by an electrochemical etching method, thereby separating the grown diamond single-crystal layer.

The non-diamond layer can be removed by electrochemical etching by, for example, the following method: two electrodes are disposed in an electrolytic solution at a certain interval, and the off-substrate containing the grown crystal layer is placed between the electrodes in the electrolytic solution, after which a voltage is applied across the electrodes. The electrolytic solution is preferably pure water. The electrode material may be any conductive material, and, in particular, chemically stable electrodes, such as platinum, graphite, and the like, are preferred. The electrode interval and the applied voltage may be adjusted to allow the etching to proceed most rapidly. The electric field strength in the electrolytic solution is typically from about 100 to about 300 V/cm.

The non-diamond layer can also be removed by thermal oxidation using, for example, the following method: in an oxygen-containing atmosphere, the off-substrate is heated to a high temperature of about 500 to about 900°C, to etch the non-diamond layer by oxidation. At this time, as etching proceeds into the off-substrate, the passage of oxygen from the outer periphery of the crystal becomes difficult. In this case, if a sufficient amount of oxygen ions are implanted beforehand, oxygen can be supplied also from the inside of the crystal, allowing the etching of the non-diamond layer to proceed further.

Through the above-described separation step, the crystal present at the surface side above the ion-implanted layer of the off-substrate (the seed crystal), and the crystal layer grown by vapor-phase synthesis are separated from the seed crystal. The surface of the separated crystal at which the crystal is separated from the substrate has an identical off-angle to the seed crystal; hence, a substrate with an identical off-angle to the seed crystal, i.e., an off-substrate, is reproduced.

Although the substrate from which the grown crystal layer has been separated has experienced a certain degree of damage caused by ion implantation, it can be used again, without any processing, as an off-substrate for crystal growth. Alternatively, the surface of the substrate may be polished by scaife polishing or the like for final polishing, so as to remove the deteriorated layer formed by ion implantation. The amount of final polishing is about equal to the thickness of the ion-implanted layer, which is typically several micrometers or less. Thus, the deteriorated layer can be removed in an extremely short period of time.

The seed crystal can be used again as an off-substrate in the same process; it can be repeatedly reused a number of times that is determined according to the value obtained by dividing the substrate thickness by the depth of the ion-implanted layer. Moreover, following the same process, a substrate with an identical off-angle can also be produced from the reproduced off-substrate. Consequently, the number of off-substrates produced can be dramatically increased.

The invention is described in greater detail below with reference to the Examples.

### Example 1

A high-temperature high-pressure synthetic Ib diamond substrate with a size of 4 × 4 × 0.4 mm³, whose surface had been polished to have an off-angle of 3.2° from the (100) plane, was used as a seed crystal (an off-substrate), and diamond growth was performed using a microwave CVD method according to the following method.

First, carbon ions were implanted into the seed crystal at an implantation energy of 3 MeV and a dose of 2 × 10¹⁶ ions/cm², using a 1.5 MV tandem accelerator. The projectile range of the implanted ions was calculated using a Monte Carlo simulation code, and the result was about 1.6 µm. As a result of this irradiation, the color of the diamond substrate changed from a pale yellow to black; this confirmed that a non-diamond layer had been formed.

The substrate was placed in a commercially available microwave plasma CVD apparatus, and then hydrogen gas was introduced into the CVD chamber, and microwave power was applied to generate plasma. Microwave power was set to about 1.7 kW, with the hydrogen gas flow rate being 500 sccm, and the pressure being 24 kPa, so that the substrate temperature was 1130°C, and these conditions were maintained for 30 minutes. This step is intended to clean the surface of the diamond substrate by exposure to hydrogen plasma, and stabilize conditions such as temperature and the like inside the CVD chamber.

Next, 60 sccm of methane gas and 0.6 sccm of nitrogen gas were introduced into the CVD chamber, and diamond growth was initiated. During the growth, microwave power was adjusted so that the temperature of the diamond substrate was maintained at 1130°C. After the introduction of methane gas, the conditions were maintained for 360 minutes to allow the growth of a crystal, and subsequently, the growth was completed by stopping the supply of methane gas.

After growing a single-crystal diamond according to the above-described method, the diamond deposited around the ion-implanted layer on the substrate-side surface was removed by laser cutting, and electrochemical etching was performed according to the following method.

First, two separate platinum electrodes were disposed at an interval of about 1 cm in a beaker containing pure water, and the substrate on which the diamond crystal had grown was placed between the electrodes. A DC voltage of 340 V was applied across the electrodes, and the substrate was allowed to stand for 12 hours; as a result, the diamond growth layer was separated from the substrate.

The thickness of the separated diamond growth layer was measured using a micrometer, and the result was 370 µm, which substantially coincided with the growth film thickness. Further, the off-angle of the separated face was measured by X-ray diffraction; as a result, the separated diamond growth layer had an off-angle of 3.2°, which was identical to the seed crystal. Thus, this growth layer is usable as an off-substrate.

### Example 2

A high-temperature high-pressure synthetic Ib diamond substrate with a size of 4 × 4 × 0.4 mm³, whose surface had been polished to have an off-angle of 2.6° from the (100) plane, was used as a seed crystal (an off-substrate), and ion implantation and diamond growth by a microwave CVD method were performed according to the same method as Example 1.

After growing a single-crystal diamond according to the above-described method, the diamond deposited around the ion-implanted layer on the substrate-side surface was removed by laser cutting, and electrochemical etching was performed to separate the diamond growth layer from the substrate, as in Example 1.

The thickness of the separated diamond growth layer was measured using a micrometer, and the result was 360 µm, which substantially coincided with the growth film thickness. Further, the off-angle of the separated face was measured by X-ray diffraction; as a result, the separated diamond growth layer had an off-angle of 2.5°, which was substantially identical to the seed crystal. Thus, this growth layer is usable as an off-substrate.

## Claims

1. A process for producing plural single-crystal diamond substrates each having an identical off-angle, comprising the steps of:
(1) implanting ions into a diamond substrate to form a layer with a deteriorated crystal structure near the surface of the substrate,
wherein the substrate is a material capable of epitaxial growth by a vapor-phase synthesis method, whose surface has an off-angle with respect to a crystal plane capable of epitaxial growth;
(2) growing a single-crystal diamond on the substrate by a vapor-phase synthesis method; and
(3) separating a grown diamond layer from the substrate at the layer with a deteriorated crystal structure,
steps (1) to (3) being further performed one or more times using the substrate from which the grown diamond layer is separated in step (3), directly or after removing the deteriorated layer formed by ion implantation.

2. The process according to claim 1, wherein a method for separating the grown diamond layer from the substrate is an electrochemical etching method, an electric discharge machining method, or a thermal oxidation method.

3. The process according to claim 1, wherein the diamond layer separated in step (3) is used as the substrate in step (1).

4. The process according to claim 1, wherein a graphitized non-diamond layer is formed near the surface of the substrate by ion implantation.

5. The process according to claim 1, wherein the vapor-phase synthesis method is a plasma CVD method, and a method for separating the grown diamond layer from the substrate is an electrochemical etching method.

6. The process according to claim 3, wherein a graphitized non-diamond layer is formed near the surface of the substrate by ion implantation.

7. The process according to claim 6, wherein the vapor-phase synthesis method is a plasma CVD method, and a method for separating the grown diamond layer from the substrate is an electrochemical etching method.

## Patentansprüche

1. Verfahren zur Herstellung mehrerer Einkristalldiamantsubstrate, von denen jedes einen identischen Neigungswinkel aufweist, umfassend die Schritte
(1) des Implantierens von Ionen in ein Diamantsubstrat zur Bildung einer Schicht mit gestörter Kristallstruktur in der Nähe der Oberfläche des Substrats,
wobei das Substrat ein Material ist, das zu epitaxialem Wachstum durch ein Gasphasensyntheseverfahren fähig ist, dessen Oberfläche einen Neigungswinkel zu einer Kristallebene, die zu epitaxialem Wachstum fähig ist, aufweist,
(2) des Züchtens eines Einkristalldiamanten auf dem Substrat durch ein Gasphasensyntheseverfahren und
(3) des Abtrennens der gezüchteten Diamantschicht von dem Substrat an der Schicht mit gestörter Kristallstruktur,
wobei Schritte (1) bis (3) weiter ein oder mehrere Male durchgeführt werden, wobei das Substrat, von dem die gezüchtete Diamantschicht in Schritt (3) abgetrennt wird, direkt oder nach dem Entfernen der gestörten Schicht, gebildet durch das lonenimplantieren, verwendet wird.

2. Verfahren nach Anspruch 1, worin ein Verfahren zum Abtrennen der gezüchteten Diamantschicht von dem Substrat ein elektrochemisches Ätzverfahren, ein Funkenerosionsverfahren oder ein thermisches Oxidationsverfahren ist.

3. Verfahren nach Anspruch 1, worin die in Schritt (3) abgetrennte Diamantschicht als das Substrat in Schritt (1) verwendet wird.

4. Verfahren nach Anspruch 1, worin eine graphitisierte Nicht-Diamantschicht in der Nähe der Oberfläche des Substrats durch lonenimplantieren gebildet wird.

5. Verfahren nach Anspruch 1, worin das Gasphasensyntheseverfahren ein Plasma-CVD-Verfahren ist und ein Verfahren zum Abtrennen der gezüchteten Diamantschicht von dem Substrat ein elektrochemisches Ätzverfahren ist.

6. Verfahren nach Anspruch 3, worin eine graphitisierte Nicht-Diamantschicht in der Nähe der Oberfläche des Substrats durch lonenimplantieren gebildet wird.

7. Verfahren nach Anspruch 6, worin das Gasphasensyntheseverfahren ein Plasma-CVD-Verfahren ist und ein Verfahren zum Abtrennen der gezüchteten Diamantschicht von dem Substrat ein elektrochemisches Ätzverfahren ist.

## Revendications

1. Procédé de production de plusieurs substrats de diamant microcristallin ayant chacun un angle décalé identique, comprenant les étapes :
(1) d'implantation d'ions dans un substrat de diamant afin de former une couche avec une structure cristalline détériorée à proximité de la surface du substrat,
dans lequel le substrat est un matériau pouvant réaliser une croissance épitaxiale par une méthode de synthèse en phase vapeur, dont la surface a un angle décalé par rapport à un plan de cristal pouvant réaliser une croissance épitaxiale ;
(2) de croissance d'un diamant monocristallin sur le substrat par une méthode de synthèse en phase vapeur ; et
(3) de séparation d'une couche de diamant ayant crû du substrat au niveau de la couche avec une structure cristalline détériorée,
les étapes (1) à (3) étant en outre réalisées une ou plusieurs fois en utilisant le substrat à partir duquel la couche de diamant ayant crû est séparée dans l'étape (3), directement ou après élimination de la couche détériorée formée par implantation ionique.

2. Procédé selon la revendication 1, dans lequel une méthode de séparation de la couche de diamant ayant crû du substrat est une méthode de gravure électrochimique, une méthode d'usinage par décharge électrique ou une méthode d'oxydation thermique.

3. Procédé selon la revendication 1, dans lequel la couche de diamant séparée dans l'étape (3) est utilisée comme substrat dans l'étape (1).

4. Procédé selon la revendication 1, dans lequel une couche non-diamant graphitisée est formée à proximité de la surface du substrat par implantation ionique.

5. Procédé selon la revendication 1, dans lequel la méthode de synthèse en phase vapeur est une méthode de dépôt chimique en phase vapeur par plasma, et une méthode de séparation de la couche de diamant ayant crû du substrat est une méthode de gravure électrochimique.

6. Procédé selon la revendication 3, dans lequel une couche non-diamant graphitisée est formée à proximité de la surface du substrat par implantation ionique.

7. Procédé selon la revendication 6, dans lequel la méthode de synthèse en phase vapeur est une méthode de dépôt chimique en phase vapeur par plasma, et une méthode de séparation de la couche de diamant ayant crû du substrat est une méthode de gravure électrochimique.
